# EUROPÄISCHE PATENTSCHRIFT

(11) **EP 2 340 568 B1**
(45) Veröffentlichungstag und Bekanntmachung des Hinweises auf die Patenterteilung: **01.03.2017**
(21) Anmeldenummer: 09741206.8
(22) Anmeldetag: 30.09.2009
(51) Int. Cl.: H01L 33/00, H01L 27/15, H01L 33/38, H01L 33/22, H01L 33/62

(54) **OPTOELEKTRONISCHER HALBLEITERKÖRPER**
OPTOELECTRONIC SEMICONDUCTOR BODY
CORPS SEMI-CONDUCTEUR OPTOÉLECTRONIQUE

(30) Priorität: 09.10.2008 DE 102008051048
(43) Veröffentlichungstag der Anmeldung: 06.07.2011
(73) Patentinhaber: OSRAM Opto Semiconductors GmbH, 93055 Regensburg (DE)
(72) Erfinder: ENGL, Karl, 93080 Pentling-OT Niedergebraching (DE); SABATHIL, Matthias, 93059 Regensburg (DE)
(74) Vertreter: Epping - Hermann - Fischer
(86) Internationale Anmeldenummer: PCT/DE2009/001379
(87) Internationale Veröffentlichungsnummer: WO 2010/040337

(56) Entgegenhaltungen:
- EP-A- 1 577 958
- EP-A1- 1 383 177
- WO-A-2005/081319
- WO-A-2005/091388
- WO-A-2007/001124
- JP-A- 2007 287 849
- US-A1- 2004 217 360
- US-A1- 2008 241 526

## Beschreibung

Die vorliegende Anmeldung betrifft einen optoelektronischen Halbleiterkörper.

Die Druckschrift US 2004/0217360 A1 betrifft eine LED mit einer Durchkontaktierung durch eine aktive Zone hindurch.

In der Druckschrift JP 2007-287849 A ist eine LED mit Durchkontaktierungen und mit flächigen Elektroden beschrieben.

Es ist eine Aufgabe der vorliegenden Anmeldung, einen optoelektronischen Halbleiterkörper anzugeben, der eine besonders hohe Gesamt-Effizienz aufweist und/oder der besonders kostengünstig herstellbar ist.

Diese Aufgabe wird durch einen optoelektronischen Halbleiterkörper gemäß Patentanspruch 1 gelöst. Vorteilhafte Ausgestaltungen und Weiterbildungen des Halbleiterkörpers sind in den abhängigen Ansprüchen angegeben.

Es wird ein optoelektronischer Halbleiterkörper angegeben, der eine Halbleiterschichtenfolge aufweist. Die Halbleiterschichtenfolge enthält eine zur Erzeugung von elektromagnetischer Strahlung geeignete aktive Schicht. Die aktive Schicht enthält einen pn-Übergang, eine Doppelheterostruktur oder eine Quantentopfstruktur wie eine Einfachquantentopfstruktur (SQW, single quantum well) oder Mehrfachquantentopfstruktur (MQW, multi quantum well) zur Strahlungserzeugung.

Die Halbleiterschichtenfolge weist mindestens eine Öffnung auf. Die Öffnung durchdringt die Halbleiterschichtenfolge in Richtung von einer Vorderseite zu einer der Vorderseite gegenüberliegenden Rückseite vollständig. Anders ausgedrückt weist die Halbleiterschichtenfolge eine Aussparung, zum Beispiel ein Loch auf, das sich über die gesamte Dicke der Halbleiterschichtenfolge erstreckt. Die Dicke ist dabei die Ausdehnung der Halbleiterschichtenfolge in Richtung von der Vorderseite zur Rückseite.

Der optoelektronische Halbleiterkörper ist zur Emission elektromagnetischer Strahlung von einer Vorderseite vorgesehen. Eine erste elektrische Anschlussschicht ist an der Rückseite des Halbleiterkörpers angeordnet. Beispielsweise bedeckt sie die Halbleiterschichtenfolge in Draufsicht auf die Rückseite stellenweise oder vollständig. Ein Teilstück der ersten elektrischen Anschlussschicht verläuft von der Rückseite her durch die Öffnung der Halbleiterschichtenfolge zur Vorderseite hin und bedeckt einen ersten Teilbereich einer vorderseitigen Hauptfläche der Halbleiterschichtenfolge.

Bei einer bevorzugten Ausgestaltung weist die Halbleiterschichtenfolge eine Mehrzahl von Öffnungen auf, die in Draufsicht auf den Halbleiterkörper beispielsweise an den Gitterpunkten eines rechteckigen, quadratischen oder hexagonalen Gitters angeordnet sind. Bei einem Halbleiterkörper mit einer Mehrzahl von Öffnungen ist jeder Öffnung ein Teilstück der ersten elektrischen Anschlussschicht zugeordnet, das durch die jeweilige Öffnung verläuft. Zudem ist jeder Öffnung ein erster Teilbereich der vorderseitigen Hauptfläche zugeordnet, der von dem jeweiligen Teilstück bedeckt ist.

In der Öffnung, oder zumindest in einem rückseitigen Teilbereich der Öffnung, ist bei einer zweckmäßigen Ausgestaltung eine Trennschicht angeordnet, welche das Teilstück der ersten elektrischen Anschlussschicht gegen die Halbleiterschichtenfolge isoliert. Auf diese Weise ist die Gefahr eines Kurzschlusses der aktiven Schicht durch das in der Öffnung angeordnete und durch einen Durchbruch der aktiven Schicht hindurch verlaufende Teilstück der ersten elektrischen Anschlussschicht vermindert. Die Trennschicht kann mit der ersten elektrischen Anschlussschicht integriert ausgebildet sein, beispielsweise durch Oxidation eines Randbereichs einer ersten elektrischen Anschlussschicht, die ein Metall enthält. Vorzugsweise ist die Trennschicht von der ersten elektrischen Anschlussschicht verschieden. Sie weist zum Beispiel ein Dielektrikum auf oder besteht daraus. Beispielsweise enthält sie Siliziumdioxid oder ein Siliziumnitrid oder besteht aus einem dieser Materialien.

Mit der ersten elektrischen Anschlussschicht kann die vorderseitige externe elektrische Kontaktierung des Halbleiterkörpers von seiner Rückseite her erfolgen. Eine elektrische Anschlussschicht für den externen elektrischen Anschluss - etwa ein Bondpad - ist auf der strahlungsemittierenden Vorderseite vorteilhafterweise nicht erforderlich. Eine solche externe elektrische Anschlussschicht vermindert in der Regel die Effizienz des Halbleiterkörpers, beispielsweise da sie die Auskopplung eines Teils der von der aktiven Schicht emittierten Strahlung behindert.

Es ist ein zweiter Teilbereich der vorderseitigen Hauptfläche von der ersten elektrischen Anschlussschicht unbedeckt. Insbesondere ist der zweite Teilbereich in Draufsicht auf die vorderseitige Hauptfläche nicht von einer elektrisch leitfähigen Schicht überdeckt. Beispielsweise stellt der zweite Teilbereich der vorderseitigen Hauptfläche eine freiliegende Außenfläche des Halbleiterkörpers dar. Es ist auch denkbar, dass der zweite Teilbereich in Draufsicht auf die vorderseitige Hauptfläche von einer oder mehreren, insbesondere strahlungsdurchlässigen, Schichten überdeckt ist. In diesem Fall ist insbesondere die Schicht oder jede der Schichten, welche den zweiten Teilbereich in Draufsicht auf die vorderseitige Hauptfläche überdeckt, elektrisch isolierend.

Es hat der Quotient aus dem Flächeninhalt einer Vorderseiten-Kontaktfläche und der Gesamtfläche der vorderseitigen Hauptfläche einen Wert von größer oder gleich 0,05. Zusätzlich hat er einen Wert von kleiner oder gleich 0,15. Mit dem Begriff Vorderseiten-Kontaktfläche wird die von der Außenkontur des ersten Teilbereichs umschlossene Fläche bezeichnet, bei einer Mehrzahl erster Teilbereiche die Summe der von den Außenkonturen der einzelnen ersten Teilbereiche jeweils umschlossenen Flächen. Der Flächeninhalt der Vorderseiten-Kontaktfläche ist die Differenz zwischen der Gesamtfläche und dem Flächeninhalt des zweiten Teilbereichs der vorderseitigen Hauptfläche. Unter dem Flächeninhalt der Vorderseiten-Kontaktfläche, dem Flächeninhalt des zweiten Teilbereichs und der Gesamtfläche der vorderseitigen Hauptfläche werden im vorliegenden Zusammenhang jeweils die Flächeninhalte der Projektionen der entsprechenden Flächen auf eine zu einer Haupterstreckungsebene der Halbleiterschichtenfolge parallele Ebene verstanden. Eine von einer planen Fläche abweichende Topografie - etwa aufgrund einer Strukturierung der vorderseitigen Hauptfläche zur Verbesserung der Lichtauskopplung - bleibt dabei unberücksichtigt.

Die Erfinder haben festgestellt, dass mit einem ersten Teilbereich beziehungsweise - bei einer Mehrzahl von Öffnungen - mit einer Mehrzahl von ersten Teilbereichen, die insgesamt 5 % oder mehr und insbesondere 15 % oder weniger der Gesamtfläche der vorderseitigen Hauptfläche bedecken, eine besonders große elektrooptische Gesamteffizienz des Halbleiterkörpers erzielt wird.

Bei einer Ausgestaltung ist der optoelektronische Halbleiterkörper ein Dünnfilm-Leuchtdiodenchip. Ein Grundprinzip eines Dünnfilm-Leuchtdiodenchips ist beispielsweise in der Druckschrift I. Schnitzer et al., Appl. Phys. Lett. 63 (16) 18. Oktober 1993, Seiten 2174 - 2176 beschrieben. Beispiele für Dünnfilm-Leuchtdiodenchips sind in den Druckschriften EP 0905797 A2 und WO 02/13281 A1 beschrieben.

Ein Dünnfilm-Leuchtdiodenchip ist in guter Näherung ein Lambert'scher Oberflächenstrahler und eignet sich von daher beispielsweise gut für die Anwendung in einem Scheinwerfer, etwa einem Kraftfahrzeugscheinwerfer.

Der Dünnfilm-Leuchtdiodenchip zeichnet sich bei einer Ausgestaltung durch mindestens eines, insbesondere durch alle der folgenden Merkmale aus:
- an einer der vorderseitigen Hauptfläche gegenüberliegenden rückseitigen Hauptfläche der Halbleiterschichtenfolge, bei der es sich insbesondere um eine strahlungserzeugende Epitaxie-Schichtenfolge handelt, ist eine reflektierende Schicht aufgebracht oder ausgebildet, die zumindest einen Teil der in der Halbleiterschichtenfolge erzeugten elektromagnetischen Strahlung in diese zurückreflektiert;
- der Dünnfilm-Leuchtdiodenchip weist - vorzugsweise an der Rückseite - ein Trägerelement auf, bei dem es sich nicht um das Wachstumssubstrat handelt, auf dem die Halbleiterschichtenfolge epitaktisch gewachsen wurde, sondern um ein separates Trägerelement, das nachträglich an der Halbleiterschichtenfolge befestigt wurde;
- die Halbleiterschichtenfolge weist eine Dicke im Bereich von 10 µm oder weniger, insbesondere im Bereich von 5 µm oder weniger auf;
- die Halbleiterschichtenfolge ist frei von einem Aufwachssubstrat. Vorliegend bedeutet "frei von einem Aufwachssubstrat, dass ein gegebenenfalls zum Aufwachsen benutztes Aufwachssubstrat von der Halbleiterschichtenfolge entfernt oder zumindest stark gedünnt ist. Insbesondere ist es derart gedünnt, dass es für sich oder zusammen mit der Epitaxie-Schichtenfolge alleine nicht freitragend ist. Der verbleibende Rest des stark gedünnten Aufwachssubstrats ist insbesondere als solches für die Funktion eines Aufwachssubstrates ungeeignet; und
- die Halbleiterschichtenfolge enthält mindestens eine Halbleiterschicht mit zumindest einer Fläche, die eine Durchmischungsstruktur aufweist, die im Idealfall zu einer annähernd ergodischen Verteilung des Lichtes in der Halbleiterschichtenfolge führt, das heißt, sie weist ein möglichst ergodisch stochastisches Streuverhalten auf.

Bei der Herstellung des Halbleiterkörpers als Dünnfilmleuchtdiodenchip kann die Ausbildung der Öffnung derart, dass sie die Halbleiterschichtenfolge vollständig durchdringt, besonders vorteilhaft sein. Bei einem Dünnfilmhalbleiterchip mit einer Öffnung, welche von der Rückseite her in Richtung der Vorderseite in die Halbleiterschichtenfolge hinein verläuft, diese jedoch nicht vollständig durchdringt, besteht eine relativ große Gefahr, die Halbleiterschichtenfolge beim Entfernen des Aufwachssubstrates zu beschädigen. Im Gegensatz zum Halbleiterkörper gemäß der vorliegenden Anmeldung ist bei einem derartigen Halbeiterkörper eine vergleichsweise große Dicke der Halbleiterschichtenfolge notwendig.

Halbleiterkörper gemäß der vorliegenden Anmeldung können vorteilhafterweise eine Halbleiterschichtenfolge mit einer besonders geringen Dicke aufweisen. Bei einer Ausgestaltung hat die Halbleiterschichtenfolge eine Dicke von 3 µm oder weniger, beispielsweise von 1 µm oder weniger. Bei einer Weiterbildung hat sie eine Dicke von 500 nm oder weniger.

Auf diese Weise ist die zur Herstellung der Halbleiterschichtenfolge benötigte Zeit besonders kurz. Die Herstellung des Halbleiterkörpers ist so besonders kostengünstig. Eine derart geringe Dicke ist zum Beispiel auch besonders vorteilhaft für eine Ausgestaltung, bei der die Halbleiterschichtenfolge eine Strukturierung aufweist, die einen photonischen Kristall darstellt. Des Weiteren ist eine derart geringe Schichtdicke vorteilhaft bei einer Halbleiterschichtenfolge, deren vorderseitige Hauptfläche und/oder rückseitige Hauptfläche eine Strukturierung aufweist, die sich bis zur aktiven Schicht hin erstreckt oder die aktive Schicht sogar durchtrennt. Mit einer derartigen Strukturierung kann der so genannte Purcell-Effekt ausgenutzt werden, mit dem eine Erhöhung der Emissionsrate der aktiven Schicht erzielt werden kann. Strukturierungen, die einen photonischen Kristall darstellen oder mit denen der Purcell-Effekt ausgenutzt werden kann, sind dem Fachmann im Prinzip bekannt und werden daher an dieser Stelle nicht näher erläutert. In Verbindung mit einem Halbleiterkörper geringer Schichtdicke kann mit solchen Strukturierungen eine besonders große optische Effizienz erzielt werden.

Es umschließt der erste Teilbereich der vorderseitigen Hauptfläche der Halbleiterschichtenfolge, der von einem Endabschnitt des ersten Teilstücks der ersten elektrischen Anschlussschicht bedeckt ist, die mindestens eine Öffnung. Anders ausgedrückt hat der erste Teilbereich bei dieser Ausgestaltung eine Außenkontur, welche in Draufsicht auf die vorderseitige Hauptfläche vollständig um die Öffnung herum verläuft. Es umschließt der erste Teilbereich die Öffnung in Draufsicht auf die Vorderseite ring-artig. Beispielsweise hat der erste Teilbereich in Draufsicht auf die vorderseitige Hauptfläche eine - zumindest im Wesentlichen - kreisförmige, ellipsenförmige oder n-eckige Außenkontur, wobei im Fall einer n-eckigen Außenkontur n ≥ 3 ist. Eine Innenkontur des ersten Teilbereichs wird von einem vorderseitigen Rand der Öffnung gebildet. Bei einer Weiterbildung hat die Halbleiterschichtenfolge eine Mehrzahl von Öffnungen, die jeweils von einem ersten Teilbereich umschlossen sind.

Es weist der Halbleiterkörper mindestens eine Vertiefung auf, die mit der mindestens einen Öffnung seiner Halbleiterschichtenfolge lateral überlappt und sich von der Vorderseite in Richtung zur Rückseite hin in die Halbleiterschichtenfolge hinein erstreckt. Es stellt die Vertiefung ein Teilgebiet der Öffnung dar. Die Vertiefung ist frei von Material der Halbleiterschichtenfolge und von Material der ersten elektrischen Anschlussschicht. Vorzugsweise ist die Vertiefung frei von fester Materie. Alternativ kann sie von einem Verkapselungsmaterial wie einem Silikon-Material oder Epoxidharz gefüllt sein.

Es begrenzt die erste elektrische Anschlussschicht, insbesondere das Teilstück der ersten elektrischen Anschlussschicht, die Vertiefung lateral und/oder in Richtung zur Rückseite hin. Es weist die erste elektrische Anschlussschicht die Vertiefung auf. Beispielsweise füllt ein Bodenabschnitt des Teilstücks einen der Rückseite zugewandten Teilbereich der Öffnung. Alternativ oder zusätzlich verläuft ein Mittelabschnitt des Teilstücks ringförmig um einen Mittelbereich der Öffnung herum. Der insbesondere zur Vorderseite offene Mittelbereich der Öffnung ist insbesondere frei von der ersten elektrischen Anschlussschicht und stellt die Vertiefung dar. Insbesondere ist die Vertiefung frei von festem Material. Alternativ kann die Vertiefung - etwa bei einem Halbleiterkörper, der in ein optoelektronisches Bauteil eingebaut ist - mit einer Verkapselungsmasse wie Epoxidharz oder einem Silikonmaterial gefüllt sein.

Die erste elektrische Anschlussschicht ist von der Halbleiterschichtenfolge verschieden und vorzugsweise frei von Halbleitermaterial. Insbesondere weist sie zumindest stellenweise ein Metall wie Silber, Gold, Aluminium und/oder Kupfer auf oder sie besteht aus mindestens einem dieser Metalle.

Es ist die erste elektrische Anschlussschicht zumindest stellenweise lichtdurchlässig oder transparent ausgebildet. Es ist das Teilstück, das durch die Öffnung hindurch verläuft, oder zumindest ein oder mehrere Abschnitte des Teilstücks lichtdurchlässig oder transparent ausgebildet. Insbesondere ist zumindest der Endabschnitt des Teilstücks, der den ersten Teilbereich der vorderseitigen Hauptfläche bedeckt, lichtdurchlässig oder transparent ausgebildet. Es weist das Teilstück oder der/die transparente(n) Abschnitt(e) des Teilstücks ein transparentes, leitfähiges Oxid wie Indium-Zinn-Oxid (ITO, indium tin oxide) auf oder besteht daraus. Ein lichtdurchlässiges Teilstück kann für die Auskoppel-Effizienz beispielsweise besonders vorteilhaft sein, wenn der Halbleiterkörper im Bereich der Öffnung eine von dem Teilstück begrenzte Vertiefung aufweist.

Ein von dem durch die Öffnung verlaufenden Teilstück verschiedenes weiteres, rückseitiges Teilstück der ersten elektrischen Anschlussschicht weist bei einer Weiterbildung ein Metall auf oder besteht daraus. Mit einer zumindest stellenweise lichtdurchlässigen ersten elektrischen Anschlussschicht, die einen zweiten Teilbereich der vorderseitigen Hauptfläche nicht bedeckt, kann eine besonders hohe Gesamt-Effizienz des Halbleiterkörpers erzielt werden.

Bei einer anderen Ausgestaltung weist die vorderseitige Hauptfläche der Halbleiterschichtenfolge Strahlungsauskoppelstrukturen auf. Unter "Strahlungsauskoppelstrukturen" werden im vorliegenden Zusammenhang Erhebungen oder Vertiefungen verstanden, die dazu vorgesehen sind, die Auskoppelung von in der aktiven Schicht erzeugter elektromagnetischer Strahlung durch Streuung zu verbessern. Strahlungsauskoppelstrukturen weisen bei einer zweckmäßigen Ausgestaltung Abmessungen im Bereich einer Wellenlänge eines Emissionsmaximums der Halbleiterschichtenfolge auf. Zum Beispiel haben benachbarte Erhebungen oder benachbarte Vertiefungen im Mittel einen Abstand und/oder eine Höhe von größer oder gleich 100 nm, vorzugsweise von größer oder gleich 300 nm. Insbesondere ist ihr Abstand und/oder ihre Höhe im Mittel kleiner oder gleich 1,5 µm vorzugsweise kleiner oder gleich 1 µm, besonders bevorzugt kleiner oder gleich 500 nm. Solche Auskoppelstrukturen sind dem Fachmann im Prinzip bekannt und werden daher an dieser Stelle nicht näher erläutert.

Bei einer bevorzugten Weiterbildung ist der erste Teilbereich frei von den Strahlungsauskoppelstrukturen. Insbesondere ist der erste Teilbereich nicht gezielt mit Strukturen versehen. Der erste Teilbereich der vorderseitigen Hauptfläche ist zum Beispiel eine glatte, insbesondere eine ebene Fläche.

Die Erfinder haben festgestellt, dass mit einem ersten Teilbereich, der frei von den Strahlungsauskoppelstrukturen ist, eine besonders gute elektrische Leitfähigkeit des Endabschnitts der ersten elektrischen Anschlussschicht erzielt werden kann. Weist der erste Teilbereich Strahlungsauskoppelstrukturen auf, besteht die Gefahr, dass die laterale Stromverteilung des Endabschnitts unbefriedigend ist. Besonders vorteilhaft ist ein erster Teilbereich, der frei von den Strahlungsauskoppelstrukturen ist für einen Halbleiterkörper, der zum Betrieb mit einem Betriebsstrom von 100 mA oder mehr, insbesondere von 500 mA oder mehr, zum Beispiel von 1 A oder mehr, bezogen auf einen Flächeninhalt der vorderseitigen Hauptfläche von einem Quadratmillimeter, betrieben wird.

Bei einer zweckmäßigen Ausgestaltung weist der Halbleiterkörper eine zweite elektrische Anschlussschicht auf, die ebenfalls an seiner Rückseite angeordnet ist und die mittels der Trennschicht oder einer weiteren Trennschicht elektrisch gegen die erste elektrische Anschlussschicht isoliert ist. Bei einer zweckmäßigen Ausgestaltung wird mittels der ersten elektrischen Anschlussschicht der Halbleiterkörper n-seitig und mittels der zweiten elektrischen Anschlussschicht p-seitig kontaktiert, oder umgekehrt. Der Halbleiterkörper mit der ersten und der zweiten elektrischen Anschlussschicht kann zur externen elektrischen Kontaktierung sowohl seiner n-Seite als auch seiner p-Seite von der Rückseite her vorgesehen sein. Die erste und/oder zweite elektrische Anschlussschicht können seitlich neben die Halbleiterschichtenfolge gezogen sein. Auf diese Weise kann die erste und/oder zweite elektrische Anschlussschicht zur externen elektrischen Kontaktierung von der Vorderseite her geeignet sein.

Bei einer zweckmäßigen Weiterbildung überlappen die erste elektrische Anschlussschicht, die zweite elektrische Anschlussschicht und die Trennschicht an der Rückseite des Halbleiterkörpers lateral. Eine derartige Ausgestaltung ist beispielsweise für einen Halbleiterkörper mit einer Mehrzahl von Öffnungen in seiner Halbleiterschichtenfolge zweckmäßig, um die erste elektrische Anschlussschicht so auszugestalten, dass die in die Öffnungen jeweils hinein verlaufenden Teilstücke an der Rückseite des Halbleiterkörpers elektrisch leitend miteinander verbunden sind. Die elektrisch leitende Verbindung ist insbesondere mit dem rückseitigen Teilstück der ersten elektrischen Anschlussschicht hergestellt.

Bei einer weiteren Ausgestaltung ist zwischen der Halbleiterschichtenfolge und der zweiten elektrischen Anschlussschicht und/oder zwischen der Halbleiterschichtenfolge und der ersten elektrischen Anschlussschicht zumindest stellenweise eine halbleitende oder elektrisch isolierende Spiegelschicht angeordnet. Mittels der Spiegelschicht wird ein von der aktiven Schicht in Richtung der Rückseite emittierter Anteil der elektromagnetischen Strahlung vorteilhafterweise in Richtung der Vorderseite emittiert. Auf diese Weise kann eine besonders hohe Effizienz der Strahlungsauskopplung erzielt werden.

Bei einer zweckmäßigen Weiterbildung weist die halbleitende oder elektrisch isolierende Spiegelschicht eine Mehrzahl von Ausnehmungen auf. Im Bereich der Ausnehmungen ist die Halbleiterschichtenfolge insbesondere in Draufsicht auf die Rückseite des Halbleiterkörpers von der Spiegelschicht unbedeckt. Die zweite elektrische Anschlussschicht erstreckt sich zweckmäßigerweise durch die Ausnehmungen hindurch zu der Halbleiterschichtenfolge hin. Auf diese Weise wird eine elektrische Verbindung zwischen der zweiten elektrischen Anschlussschicht und der Halbleiterschichtenfolge durch die elektrisch isolierende oder halbleitende Spiegelschicht hindurch hergestellt.

Bei einer weiteren Ausgestaltung verjüngt sich die mindestens eine Öffnung in Richtung von der Vorderseite zur Rückseite hin. Anders ausgedrückt hat die Öffnung an der Vorderseite einen größeren Querschnitt als an der Rückseite. Auf diese Weise kann - insbesondere bei einer Ausgestaltung, bei der der Mittelbereich der Öffnung frei von der ersten elektrischen Anschlussschicht ist und der Halbleiterkörper in diesem Bereich die Vertiefung aufweist - eine besonders gute Auskoppelung elektromagnetischer Strahlung von den Flanken der Vertiefung erfolgen.

Bei einer anderen Ausgestaltung verjüngt sich die Öffnung in Richtung von der Rückseite zur Vorderseite hin. Eine derartige Ausgestaltung ist insbesondere zweckmäßig, wenn die Vertiefung vollständig von der ersten elektrischen Anschlussschicht gefüllt ist.

Bei einer alternativen Ausführungsform verläuft die ringförmig umlaufende Seitenfläche der Öffnung oder verlaufen die Seitenflächen der Öffnung im wesentlichen senkrecht zu einer Haupterstreckungsebene der Halbleiterschichtenfolge.

Weitere Vorteile und vorteilhafte Ausgestaltungen und Weiterbildungen des Halbleiterkörpers ergeben sich aus den im Zusammenhang mit den Figuren 1 bis 6 erläuterten exemplarischen Ausführungsbeispielen und nicht erfindungsgemäßen Abwandlungen.

Es zeigen:
- Figur 1: eine schematisch Schnittdarstellung eines optoelektronischen Halbleiterkörpers gemäß einem Ausführungsbeispiel,
- Figur 2: eine schematische Schnittdarstellung eines optoelektronischen Halbleiterkörpers gemäß einer nicht erfindungsgemäßen Abwandlung,
- Figur 3: eine schematische Schnittdarstellung eines optoelektronischen Halbleiterkörpers gemäß einer nicht erfindungsgemäßen Abwandlung,
- Figur 4: eine schematische Draufsicht auf den optoelektronischen Halbleiterkörper gemäß dem Ausführungsbeispiel der Figur 1,
- Figur 5: eine schematische Draufsicht auf einen Ausschnitt eines optoelektronischen Halbleiterkörpers gemäß einer Variante des Ausführungsbeispiels der Figur 1, und
- Figur 6: die relative elektrooptische Gesamteffizienz des Halbleiterkörpers gemäß dem Ausführungsbeispiel der Figur 1 in Abhängigkeit von der Bedeckung einer vorderseitigen Hauptfläche durch die erste elektrische Anschlussschicht.

In den Ausführungsbeispielen und Figuren sind ähnliche oder ähnlich wirkende Bestandteile mit denselben Bezugszeichen versehen. Die Figuren und die Größenverhältnisse der in den Figuren dargestellten Elemente sind nicht als maßstabsgetreu zu betrachten, es sei denn, eine Skala ist explizit angegeben. Vielmehr können einzelne Elemente, zum Beispiel Schichten, übertrieben groß beziehungsweise dick dargestellt sein, um die Darstellbarkeit und/oder die Verständlichkeit der Figuren zu verbessern.

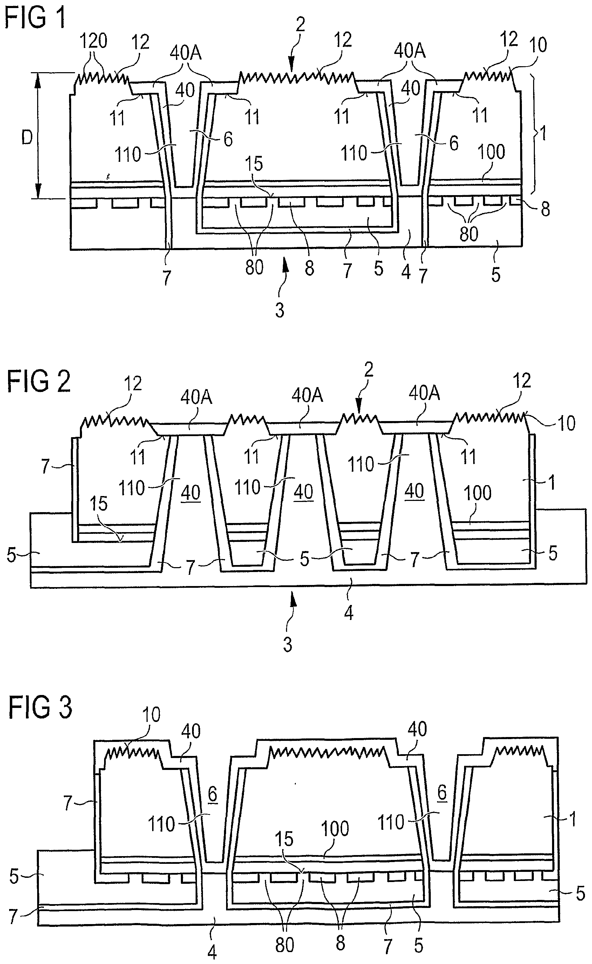

Figur 1 zeigt ein exemplarisches Ausführungsbeispiel eines optoelektronischen Halbleiterköpers. Der optoelektronische Halbleiterkörper weist eine epitaktische Halbleiterschichtenfolge 1 auf, von der das Aufwachssubstrat abgetrennt ist. Eine an einer Vorderseite 2 des Halbleiterkörpers angeordnete vorderseitige Hauptfläche 10 der Halbleiterschichtenfolge 1 ist zur Strahlungsauskopplung vorgesehen. An einer der Vorderseite 2 gegenüberliegenden Rückseite 3 ist auf der rückseitigen Hauptfläche 15 der Halbleiterschichtenfolge 1 eine dielektrische Spiegelschicht 8 aufgebracht. Zwischen der vorderseitigen Hauptfläche 10 und der rückseitigen Hauptfläche 15 enthält die Halbleiterschichtenfolge 1 eine aktive Schicht 100, die zur Erzeugung von elektromagnetischer Strahlung vorgesehen ist. Die Halbleiterschichtenfolge 1 hat vorliegend eine Dicke D von 1 µm. Die Dicke ist dabei die Abmessung von der rückseitigen Hauptfläche 15 zur vorderseitigen Hauptfläche 10.

Die Halbleiterschichtenfolge 1 weist eine Mehrzahl von Öffnungen 110 auf, von denen in Figur 1 zur Vereinfachung nur zwei dargestellt sind. Die Öffnungen 110 durchdringen die Halbleiterschichtenfolge 1 in Richtung von der Vorderseite 2 zur Rückseite 3 vollständig. Insbesondere durchbrechen sie auch die aktive Schicht 100. Die Öffnungen 110 sind frei von Material der Halbleiterschichtfolge 1. Vorliegend haben sie einen kreisförmigen Querschnitt. Sie verjüngen sich bei dem Halbleiterkörper des ersten Ausführungsbeispiels in Richtung von der Vorderseite 2 zur Rückseite 3 hin.

An der Rückseite 3 des Halbleiterkörpers ist eine erste elektrische Anschlussschicht 4 angeordnet. Jeweils ein Teilstück 40 der ersten elektrischen Anschlussschicht 4 erstreckt sich ausgehend von der Rückseite 3 in eine Öffnung 110 der Halbleiterschichtenfolge 1 hinein und verläuft durch diese hindurch bis zur Vorderseite 2 des Halbleiterkörpers, wo ein Endabschnitt 40A des Teilstücks 40 einen ersten Teilbereich 11 der Vorderseite - genauer der vorderseitigen Hauptfläche 10 - bedeckt. Die ersten Teilbereiche 11 umgeben die jeweiligen Öffnungen 110 ringförmig. Ein zweiter Teilbereich 12 der vorderseitigen Hauptfläche 10 ist von der ersten elektrischen Anschlussschicht 4 unbedeckt. Der zweite Teilbereich 12 stellt vorliegend eine freiliegende Außenfläche des Halbleiterkörpers dar.

Der zweite Teilbereich 12 weist bei dem vorliegenden Ausführungsbeispiel Lichtauskoppelstrukturen 120 auf. Dagegen sind die ersten Teilbereiche 11 frei von den Lichtauskoppelstrukturen 120 und stellen plane Flächenabschnitte dar.

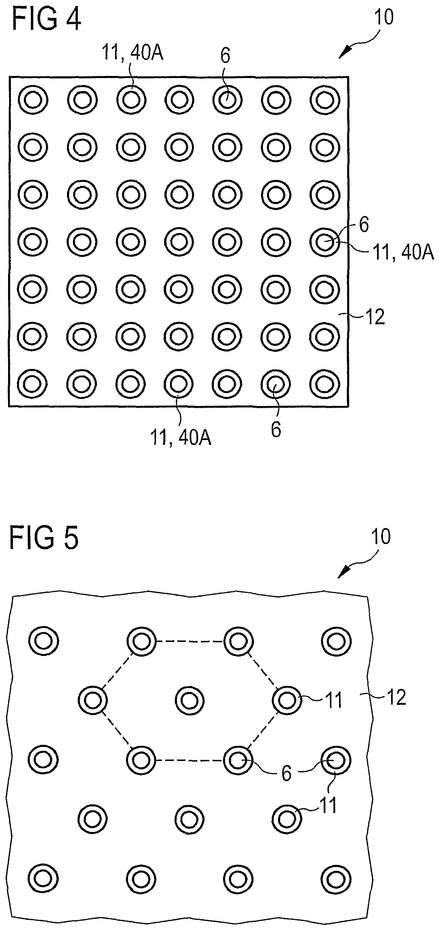

In Figur 4 ist dies in einer schematischen Draufsicht auf die Vorderseite 2 des Halbleiterkörpers dargestellt. Die Halbleiterschichtenfolge 1 hat beispielsweise eine quadratische Grundfläche. Die Öffnungen 110 sind beispielsweise in sieben Reihen und sieben Spalten - insbesondere an den Gitterpunkten eines quadratischen Gitters - angeordnet. Die Endabschnitte 40A der durch die Öffnungen 110 verlaufenden Teilstücke 40 der ersten elektrischen Anschlussschicht 4 bedecken die ersten Teilbereiche 11 der vorderseitigen Hauptfläche 10 und umgeben Vertiefungen 6. Ein zweiter Teilbereich 12 ist von der ersten elektrischen Anschlussschicht 4 unbedeckt.

Die Teilstücke 40 der ersten elektrischen Anschlussschicht 4 füllen bei dem vorliegenden Ausführungsbeispiel die jeweilige Öffnung 110 nicht vollständig auf. Lediglich ein Bodenabschnitt des Teilstücks 40 füllt einen rückseitigen Teilbereich der Öffnung 110 vollständig aus. Ein in Richtung der Vorderseite 2 nachfolgender Mittelabschnitt des Teilstücks 40, der im Bereich der Öffnung 110 angeordnet ist, ist nur als Schicht ausgebildet, welche die ringförmig umlaufende Seitenfläche der Öffnung 110 überdeckt. Der in Richtung der Vorderseite 2 an den Mittelabschnitt angrenzende Endabschnitt 40A des Teilstücks 40 ist ebenfalls ringförmig ausgebildet. Das Teilstück 40 weist also vorliegend die Form eines rückseitig mittels des Bodenabschnitts geschlossenen Rohrs auf, das vorderseitig einen von dem Endabschnitt 40A gebildeten Kragen aufweist. Der Mittelabschnitt bildet die Seitenwand des Rohrs.

So ist ein zur Vorderseite 2 hin geöffneter Mittelbereich der Öffnung 110 frei von Material der ersten elektrischen Anschlussschicht 4 und frei von Material des Teilstücks 40 der elektrischen Anschlussschicht 4. Auf diese Weise sind die Vertiefungen 6 des Halbleiterkörpers gebildet, die sich jeweils im Bereich einer Öffnung 110 von der Vorderseite 2 her in Richtung zur Rückseite 3 in die Halbleiterschichtenfolge 1 hinein erstrecken.

Das durch die Öffnung 110 verlaufende Teilstück 40 der ersten elektrischen Anschlussschicht 4 ist transparent ausgebildet.

Es weist ein transparentes, leitfähiges Oxid wie Indium-Zinn-Oxid (ITO) auf oder besteht daraus.

Ein weiteres, rückseitiges Teilstück der ersten elektrischen Anschlussschicht 4, das in Richtung zur Rückseite 3 hin an das Teilstück 40 angrenzt, weist vorzugsweise ein metallisches Material auf oder besteht daraus. Vorliegend besteht die erste elektrische Anschlussschicht aus dem transparenten, durch die Öffnung 110 hindurch verlaufenden Teilstück 40 und dem metallischen, rückseitigen Teilstück.

Das Teilstück 40 ist mittels einer Trennschicht 7 gegen die umlaufende Seitenfläche der Öffnung 110 elektrisch isoliert. Im Bereich der Öffnung 10 ist die Trennschicht 7 in lateraler Richtung zwischen dem Teilstück 40 und der Halbleiterschichtenfolge 1 angeordnet. Zwischen der vorderseitigen Hauptfläche 10 der Halbleiterschichtenfolge 1 und dem Endabschnitt 40A des Teilstücks 40 ist im Gegensatz hierzu ein elektrischer Kontakt hergestellt.

Die Trennschicht 7 isoliert die erste elektrische Anschlussschicht 4 vorliegend auch von einer zweiten elektrischen Anschlussschicht 5, die ebenfalls an der Rückseite 3 des Halbleiterkörpers angeordnet ist. Die zweite elektrische Anschlussschicht 5 erstreckt sich von der Rückseite 3 her durch Ausnehmungen 80 der elektrisch isolierenden Spiegelschicht 8 hindurch zur rückseitigen Hauptfläche 15 der Halbleiterschichtenfolge 1. Vorliegend ist die erste elektrische Anschlussschicht zum n-seitigen Anschließen und die zweite elektrische Anschlussschicht zum p-seitigen Anschließen des Halbleiterkörpers vorgesehen.

Ein Teilbereich der ersten elektrischen Anschlussschicht 4, ein Teilbereich der Trennschicht 7 und ein Teilbereich der zweiten elektrischen Anschlussschicht 5 überlappen an der Rückseite 3 des Halbleiterkörpers lateral. Dies ist beispielsweise im mittleren Bereich der Figur 1 der Fall, wo die erste elektrische Anschlussschicht 4, die Trennschicht 7 und die zweite elektrische Anschlussschicht 5 in Richtung von der Rückseite 3 zur Vorderseite 2 aufeinander folgen. Auf diese Weise sind die einzelnen Teilstücke 40, die in den jeweiligen Öffnungen 110 der Halbleiterschichtenfolge 1 angeordnet sind, elektrisch leitend mittels des rückseitigen Teilstücks der ersten elektrischen Anschlussschicht 4 miteinander elektrisch leitend verbunden.

Bei dem vorliegenden Ausführungsbeispiel ist der Halbleiterkörper zur externen elektrischen Kontaktierung seiner n-Seite und seiner p-Seite von der Rückseite 3 her vorgesehen. Alternativ kann die erste elektrische Anschlussschicht 1 und/oder die zweite elektrische Anschlussschicht 5 auch seitlich neben die Halbleiterschichtenfolge 1 gezogen sein, so dass sie zur Kontaktierung von der Vorderseite her geeignet ist/sind. Derartige Ausgestaltungen sind im Zusammenhang mit den Abwandlungen der Figuren 2 und 3 gezeigt.

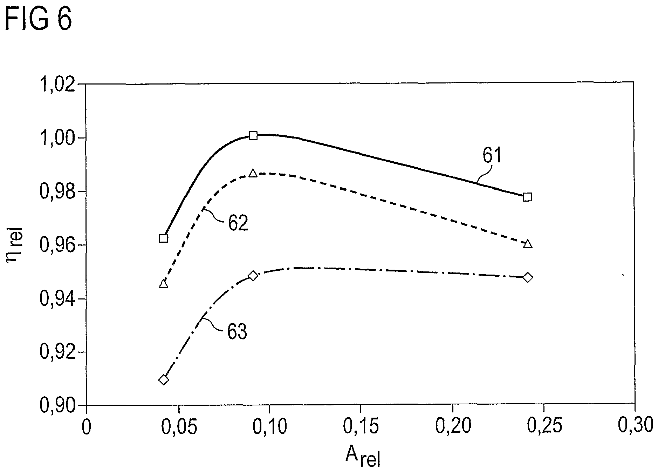

Figur 6 zeigt die relative elektrooptische Gesamteffizienz ηᵣₑₗ des Halbleiterkörpers gemäß dem Ausführungsbeispiel der Figur 1 in Abhängigkeit von der relativen Kontaktfläche Aᵣₑₗ. Die relative Kontaktfläche ist dabei der Quotient aus der Fläche, die von den Außenkonturen der ersten Teilbereiche 11 eingeschlossen wird, zur Gesamtfläche der vorderseitigen Hauptfläche 10 der Halbleiterschichtenfolge 1. Die Gesamtfläche ist die Summe aus den ersten Teilflächen 11 und der zweiten Teilfläche 12. Die Flächen sind dabei jeweils in Projektion auf die Haupterstreckungsebene der Halbleiterschichtenfolge 1 zu verstehen, so dass eine Vergrößerung der tatsächlichen Fläche - beispielsweise durch die Erhebungen, welche die Auskoppelstrukturen 120 bilden - nicht berücksichtigt wird.

In Figur 6 sind drei Kurven dargestellt. Die Kurve 61 beschreibt die elektrooptische Gesamteffizienz ηᵣₑₗ für den Fall planer erster Teilbereiche 11, die von einem 100 nm dicken Endabschnitt 40A der ersten elektrischen Anschlussschicht 4 bedeckt sind, der aus ITO besteht. Bei der Kurve 62 sind die ersten Teilbereiche 11 ebenfalls plan, jedoch ist die Dicke des Endabschnitts 40A gleich 30 nm gewählt. Bei der Kurve 63 weisen die ersten Teilbereiche 11 zum Vergleich Auskoppelstrukturen 120 auf; die Dicke des Endabschnittes 40A, welcher auf die Auskoppelstrukturen des ersten Teilbereichs 11 aufgebracht ist, beträgt bei dem in Kurve 63 dargestellten Fall 100 nm.

Aus diesen Berechnungen geht klar hervor, dass bei planen ersten Teilbereichen 11 die elektrooptischen Gesamteffizienz ηᵣₑₗ im Vergleich zu aufgerauten ersten Teilbereichen erhöht ist. Ein Maximum der elektrooptischen Gesamteffizienz ergibt sich bei einer relativen Kontaktfläche Aᵣₑₗ zwischen 5% und 15%, vorzugsweise zwischen 7% und 12%. Eine bevorzugte Schichtdicke der Endabschnitte 40A der ersten elektrischen Anschlussschicht beträgt zwischen 30 nm und 100 nm.

Figur 2 zeigt eine nicht erfindungsgemäße Abwandlung eines optoelektronischen Halbleiterkörpers. Der optoelektronische Halbleiterkörper gemäß dieser Abwandlung unterscheidet sich zunächst dadurch von dem des Ausführungsbeispiels der Figur 1, dass sowohl die erste als auch die zweite elektrische Anschlussschicht 4, 5 seitlich neben die Halbleiterschichtenfolge 1 gezogen sind. So ist der Halbleiterkörper zum n-seitigen und p-seitigen externen Anschließen von seiner Vorderseite 2 her geeignet. Der Halbleiterkörper kann auch zum n-seitigen und p-seitigen externen Anschließen von seiner Rückseite 3 her vorgesehen sein, wie in Zusammenhang mit dem Ausführungsbeispiel der Figur 1 erläutert.

Weiterhin unterscheidet sich der Halbleiterkörper gemäß dieser Abwandlung von demjenigen des Ausführungsbeispiels der Figur 1 darin, dass die durch die Öffnungen 110 verlaufenden Teilstücke 40 der ersten elektrischen Anschlussschicht 4 die Öffnungen 110 jeweils vollständig ausfüllen. Vorliegend bestehen die Teilstücke 40 im Bereich der Öffnungen 110 aus einem metallischen Material. Lediglich Endabschnitte 40A, welche die ersten Teilbereiche 110 der vorderseitigen Hauptfläche 10 bedecken, bestehen aus einem transparenten, leitfähigen Oxid wie ITO. Die Endabschnitte 40A sind vorliegend auch nicht ringförmig, wie beim Ausführungsbeispiel der Figur 1, sondern haben die Form eines Vollzylinders oder, bei einer Variante, eines Quaders. Jeder Endabschnitt 40A grenzt insbesondere an eine vorderseitige Endfläche des metallischen Abschnitts des Teilstücks 40 an, bedeckt diese Endfläche vollständig und ragt seitlich über sie hinaus.

Figur 3 zeigt eine weitere nicht erfindungsgemäße Abwandlung eines optoelektronischen Halbleiterkörpers. Diese Abwandlung entspricht im Wesentlichen dem Ausführungsbeispiel der Figur 1. Abweichend von diesem ist die zweite elektrische Anschlussschicht zum externen elektrischen Anschluss von der Vorderseite her vorgesehen, während die erste elektrische Anschlussschicht 4 zum externen elektrischen Anschluss von der Rückseite her vorgesehen ist. Eine solche Ausgestaltung der externen elektrischen Anschlüsse ist auch für die übrigen Ausführungsbeispiele geeignet.

Zusätzlich bedeckt bei dem Halbleiterkörper gemäß der Abwandlung der Figur 3 beispielsweise die erste elektrische Anschlussschicht 4 die vorderseitige Hauptfläche 10 der Halbleiterschichtenfolge 1 vollständig. Insbesondere erstreckt sich vorliegend das durch die Öffnungen 110 verlaufende, strahlungsdurchlässige Teilstück 40, das beispielsweise ein TCO aufweist oder daraus besteht, über die gesamte vorderseitige Hauptfläche 10. Eine derartige Ausgestaltung kann beispielsweise vorteilhaft sein, wenn der Halbleiterkörper zum Betrieb mit besonders großen Betriebsströmen vorgesehen ist. Alternativ kann auch, wie beim Ausführungsbeispiel der Figur 1, ein Teilbereich 12 der vorderseitigen Hauptfläche 10 von der ersten elektrischen Anschlussschicht 4 unbedeckt sein.

Figur 5 zeigt eine schematische Draufsicht auf einen Ausschnitt der vorderseitigen Hauptfläche 10 eines Halbleiterkörpers gemäß einer Variante des Ausführungsbeispiels der Figur 1. Im Gegensatz zum Ausführungsbeispiel der Figur 1 sind die Öffnungen 110 mit den sie ringförmig umschließenden ersten Teilbereichen 11 der vorderseitigen Hauptfläche 10 nicht an den Gitterpunkten eines rechteckigen Gitters angeordnet. Stattdessen sind sie an den Gitterpunkten eines hexagonalen Gitters angeordnet, angedeutet durch die gestrichelten Linien in Figur 5.

Mittels einer derartigen Anordnung kann eine besonders homogene Stromverteilung erzielt werden. Dies ist insbesondere vorteilhaft, wenn der Halbleiterkörper eine große Anzahl von Öffnungen 110 - zum Beispiel 100 Öffnungen oder mehr - aufweist.

## Patentansprüche

1. Optoelektronischer Halbleiterkörper mit einer Halbleiterschichtenfolge (1), die eine zur Erzeugung von elektromagnetischer Strahlung geeignete aktive Schicht (100) aufweist, und einer ersten elektrischen Anschlussschicht (4), wobei
- der Halbleiterkörper zur Emission elektromagnetischer Strahlung von einer Vorderseite (2) vorgesehen ist,
- die Halbleiterschichtenfolge (1) eine Öffnung (110) aufweist, welche die Halbleiterschichtenfolge (1) in Richtung von der Vorderseite (2) zu einer der Vorderseite (2) gegenüberliegenden Rückseite (3) vollständig durchdringt,
- die erste elektrische Anschlussschicht (4) an der Rückseite (3) des Halbleiterkörpers angeordnet ist,
- ein Teilstück (40) der ersten elektrischen Anschlussschicht (4) von der Rückseite (3) her durch die Öffnung (110) zur Vorderseite (2) hin verläuft und einen ersten Teilbereich (11) einer vorderseitigen Hauptfläche (10) der Halbleiterschichtenfolge (1) bedeckt,
- die erste elektrische Anschlussschicht (4) zumindest stellenweise lichtdurchlässig ausgebildet ist, und
- ein zweiter Teilbereich (12) der vorderseitigen Hauptfläche (10) von der ersten elektrischen Anschlussschicht (4) unbedeckt ist,
und das Teilstück (40, 40A) der ersten elektrischen Anschlussschicht (4) ein transparentes leitfähiges Oxid aufweist oder daraus besteht,
**dadurch gekennzeichnet, dass**
- der Halbleiterkörper eine Vertiefung (6) aufweist, die mit der Öffnung (110) lateral überlappt und sich von der Vorderseite (2) in Richtung zur Rückseite (3) hin in die Halbleiterschichtenfolge (1) hinein erstreckt,
- die erste elektrische Anschlussschicht (4) die Vertiefung lateral und/oder in Richtung zur Rückseite (3) hin begrenzt,
- der erste Teilbereich (11) der vorderseitigen Hauptfläche (10) der Halbleiterschichtenfolge (1), der von der ersten elektrischen Anschlussschicht (4, 40) bedeckt ist, die Öffnung (110) ringartig umschließt, und alternativ oder zusätzlich ein Quotient aus dem Flächeninhalt einer Vorderseiten-Kontaktfläche und der Gesamtfläche der vorderseitigen Hauptfläche (10) einen Wert von größer oder gleich 0,05 und kleiner oder gleich 0,15 hat, wobei der Flächeninhalt der Vorderseiten-Kontaktfläche gleich der Differenz zwischen der Gesamtfläche und dem Flächeninhalt des zweiten Teilbereichs (12) ist.

2. Optoelektronischer Halbleiterkörper gemäß Anspruch 1, bei dem die erste elektrische Anschlussschicht (4) die Vertiefung (6) aufweist.

3. Optoelektronischer Halbleiterkörper gemäß einem der vorhergehenden Ansprüche, bei dem die vorderseitige Hauptfläche (10) Strahlungsauskoppelstrukturen (120) aufweist und der erste Teilbereich (11) frei von den Strahlungsauskoppelstrukturen (120) ist.

4. Optoelektronischer Halbleiterkörper gemäß einem der vorhergehenden Ansprüche mit einer zweiten elektrischen Anschlussschicht (5), die ebenfalls an der Rückseite (3) angeordnet ist und die mittels einer Trennschicht (7) elektrisch gegen die erste elektrische Anschlussschicht (4) isoliert ist.

5. Optoelektronischer Halbleiterkörper gemäß Anspruch 4, bei dem an der Rückseite (3) des Halbleiterkörpers die erste elektrische Anschlussschicht (4), die zweite elektrische Anschlussschicht (5) und die Trennschicht (7) lateral überlappen.

6. Optoelektronischer Halbleiterkörper gemäß einem der Ansprüche 4 oder 5, wobei zwischen der Halbleiterschichtenfolge (1) und der zweiten elektrischen Anschlussschicht (5) stellenweise eine halbleitende oder elektrisch isolierende Spiegelschicht (8) angeordnet ist, die eine Mehrzahl von Ausnehmungen (80) aufweist, und sich die zweite elektrische Anschlussschicht (5) durch die Ausnehmungen (80) hindurch zu der Halbleiterschichtenfolge (1) hin erstreckt.

7. Optoelektronischer Halbleiterkörper gemäß einem der vorhergehenden Ansprüche, bei dem die Halbleiterschichtenfolge (1) eine Dicke (D) von 3 µm oder weniger hat.

8. Optoelektronischer Halbleiterkörper gemäß einem der vorhergehenden Ansprüche, bei dem sich die Öffnung (110) in Richtung von der Vorderseite (2) zur Rückseite (3) hin oder in Richtung von der Rückseite (3) zur Vorderseite (2) hin verjüngt.

## Claims

1. Optoelectronic semiconductor body with a semiconductor layer sequence (1), which comprises an active layer (100) suitable for generating electromagnetic radiation, and with a first electrical connection layer (4),
wherein
- the semiconductor body is provided for emitting electromagnetic radiation from a front side (2),
- the semiconductor layer sequence (1) comprises an opening (110), which completely penetrates the semiconductor layer sequence (1) in the direction from the front side (2) to a rear side (3) located opposite the front side (2),
- the first electrical connection layer (4) is arranged on the rear side (3) of the semiconductor body,
- a section (40) of the first electrical connection layer (4) extends from the rear side (3) through the opening (110) to the front side (2) and covers a first partial region (11) of a front-side main face (10) of the semiconductor layer sequence (1),
- the first electrical connection layer (4) is formed so as to be permeable to light at least in places,
and
- a second partial region (12) of the front-side main face (10) is not covered by the first electrical connection layer (4), and the section (40, 40A) of the first electrical connection layer (4) comprises a transparent conductive oxide or consists thereof,
**characterized in that**
- the semiconductor body comprises a depression (6), which laterally overlaps the opening (110) and extends into the semiconductor layer sequence (1) from the front side (2) in the direction towards the rear side (3),
- the first electrical connection layer (4) delimits the depression laterally and/or in the direction towards the rear side (3),
- the first partial region (11) of the front-side main face (10) of the semiconductor layer sequence (1), which is covered by the first electrical connection layer (4, 40), surrounds the opening (110) in the manner of a ring, and alternatively or additionally a quotient of the surface area of a front-side contact surface and the total surface area of the front-side main face (10) has a value of greater than or equal to 0.05 and less than or equal to 0.15, wherein the surface area of the front-side contact surface is equal to the difference between the total surface area and the surface area of the second partial region (12).

2. Optoelectronic semiconductor body according to Claim 1, in which the first electrical connection layer (4) comprises the depression (6).

3. Optoelectronic semiconductor body according to either of the preceding claims, in which the front-side main face (10) comprises radiation coupling-out structures (120), and the first partial region (11) is free from the radiation coupling-out structures (120).

4. Optoelectronic semiconductor body according to one of the preceding claims, with a second electrical connection layer (5), which is likewise arranged on the rear side (3) and which is electrically insulated with respect to the first electrical connection layer (4) by means of a separating layer (7).

5. Optoelectronic semiconductor body according to Claim 4, in which the first electrical connection layer (4), the second electrical connection layer (5) and the separating layer (7) overlap laterally on the rear side (3) of the semiconductor body.

6. Optoelectronic semiconductor body according to either of Claims 4 and 5, wherein a semiconducting or electrically insulating mirror layer (8) comprising a plurality of recesses (80) is arranged in places between the semiconductor layer sequence (1) and the second electrical connection layer (5), and the second electrical connection layer (5) extends through the recesses (80) to the semiconductor layer sequence (1).

7. Optoelectronic semiconductor body according to one of the preceding claims, in which the semiconductor layer sequence (1) has a thickness (D) of 3 µm or less.

8. Optoelectronic semiconductor body according to one of the preceding claims, in which the opening (110) tapers in the direction from the front side (2) towards the rear side (3) or in the direction from the rear side (3) towards the front side (2).

## Revendications

1. Corps semi-conducteur optoélectronique avec une séquence de couches (1) semi-conductrices qui comporte une couche (100) active adaptée pour générer un rayonnement électromagnétique et une première couche de raccordement (4) électrique,
- le corps semi-conducteur étant prévu pour émettre un rayonnement électromagnétique à partir d'une face avant (2),
- la séquence de couches (1) semi-conductrices comportant un orifice (110), lequel traverse totalement la séquence de couches (1) semi-conductrices dans la direction à partir de la face avant (2) vers une face arrière (3) opposée à la face avant (2),
- la première couche de raccordement (4) électrique étant placée sur la face arrière (3) du corps semi-conducteur,
- une parcelle (40) de la première couche de raccordement (4) électrique s'écoulant à partir de la face arrière (3) à travers l'orifice (110) vers la face avant (2) et recouvrant une première zone partielle (11) d'une surface principale (10) avant de la séquence de couches (1) semi-conductrices ,
- la première couche de raccordement (4) électrique étant conçue en étant transparente au moins par endroits et
- une deuxième zone partielle (12) de la surface principale (10) avant n'étant pas recouverte par la première couche de raccordement (4) électrique,
- et la parcelle (40, 40A) de la première couche de raccordement (4) électrique comportant un oxyde transparent conducteur ou étant constituée de celui-ci,
**caractérisé en ce que**
- le corps semi-conducteur comporte un creux (6) qui chevauche latéralement l'orifice (110) et s'étend à partir de la face avant (2) dans la direction de la face arrière (3), à l'intérieur de la séquence de couches (1) semi-conductrices,
- la première couche de raccordement (4) électrique délimite le creux latéralement et/ou en direction vers la face arrière (3),
- la première zone partielle (11) de la surface principale (10) avant de la séquence de couches (1) semi-conductrices qui est recouverte par la première couche de raccordement (4, 40) électrique entoure l'orifice (110) à la manière d'un anneau et alternativement ou en supplément, un quotient de l'unité de surface d'une surface de contact sur la face avant et de la surface totale de la surface principale (10) avant a une valeur supérieure ou égale à 0,05 et inférieure ou égale à 0,15, la superficie de la surface de contact de la face avant étant égale à la différence entre la surface totale et la superficie de la deuxième zone partielle (12).

2. Corps semi-conducteur optoélectronique selon la revendication 1, sur lequel la première couche de raccordement (4) électrique comporte le creux (6).

3. Corps semi-conducteur optoélectronique selon l'une quelconque des revendications précédentes, sur lequel la surface principale (10) avant comporte des structures de découplage (120) d'un rayonnement et la première zone partielle (11) est exempte de structures de découplage (120) d'un rayonnement.

4. Corps semi-conducteur optoélectronique selon l'une quelconque des revendications précédentes, avec une deuxième couche de raccordement (5) électrique, qui est également placée sur la face arrière (3) et qui est électriquement isolée par rapport à la première couche de raccordement (4) électrique par l'intermédiaire d'une couche de séparation (7).

5. Corps semi-conducteur optoélectronique selon la revendication 4, sur lequel, sur la face arrière (3) du corps semi-conducteur, la première couche de raccordement (4) électrique, la deuxième couche de raccordement (5) électrique et la troisième couche de séparation (7) se chevauchent latéralement.

6. Corps semi-conducteur optoélectronique selon l'une quelconque des revendications 4 ou 5, entre la séquence de couches (1) semi-conductrices et la deuxième couche de raccordement (5) électrique étant placée par endroits une couche réflectrice (8) semi-conductrice ou isolante électrique qui comporte une pluralité d'évidements (80) et la deuxième couche de raccordement (5) électrique s'étendant en passant à travers les évidements (80) vers la séquence de couches (1) semi-conductrices.

7. Corps semi-conducteur optoélectronique selon l'une quelconque des revendications précédentes, sur lequel la séquence de couches (1) semi-conductrices a une épaisseur (D) de 3 µm ou moins.

8. Corps semi-conducteur optoélectronique selon l'une quelconque des revendications précédentes, sur lequel l'orifice (110) se rétrécit en direction de la face avant (2) vers la face arrière (3) ou dans la direction de la face arrière (3) vers la face avant (2).
